# EUROPEAN PATENT SPECIFICATION

(11) **EP 0 288 215 B1**
(45) Date of publication and mention of the grant of the patent: **10.03.1993**
(21) Application number: 88303383.9
(22) Date of filing: 14.04.1988
(51) Int. Cl.: G01F 23/26, G01F 25/00, G01F 23/24

(54) **Determination of electrical capacitance and resistance**
Bestimmung von elektrischer Kapazität und elektrischem Widerstand
Détermination de capacité et de résistance électriques

(30) Priority: 24.04.1987 US 42229
(43) Date of publication of application: 26.10.1988
(73) Proprietor: SIMMONDS PRECISION PRODUCTS INC., Akron, Ohio 44334-0501 (US)
(72) Inventor: Maier, Lawrence Carl, Vermont 05753 (US)
(74) Representative: Foster, David Martyn

(56) References cited:
- GB-A- 2 058 364
- US-A- 4 080 562
- US-A- 4 147 050

## Description

The invention relates to apparatus for determining capacitance and resistance characteristics of an electrical component, comprising voltage applying means for subjecting the electrical component to a time varying voltage having a linear ramp voltage which passes from a first polarity through zero to a second polarity and for subjecting the electrical component to a fixed voltage level, sensing means operative in response to the zero crossing of the ramp voltage to sense the electrical potential across the electrical component and for sensing the potential across the electrical component when the voltage is at the fixed voltage level, and means for determining the capacitance of the electrical component from the potential sensed in response to the zero crossing and for determining the resistance of the electrical component from the potential sensed at the fixed voltage level.

The invention also relates to a method of determining capacitive and resistive characteristics of an electrical component, comprising the steps of subjecting the component to a time varying voltage having a linear ramp voltage which passes from a first polarity through zero to a second polarity, subjecting the electrical component to a fixed voltage level, sensing the potential across the electrical component in response to the zero crossing of the ramp voltage, sensing the potential across the electrical component when the voltage is at the fixed voltage level, determining the capacitance of the electrical component from the potential sensed in response to the zero crossing, and determining the resistance of the electrical component from the potential sensed at the fixed voltage level.

A form of such apparatus and method is known from US-A-4 080 562 and from US-A-4 147 050. In such apparatus and method, an oscillator produces a triangular electrical waveform which is applied across the electrical component via a switch. A sample and hold arrangement samples the voltage developed across the electrical component at instants corresponding to the zero crossing points of the triangular waveform. The capacitance of the component differentiates the triangular waveform to produce a square wave displaced by 90° from the triangular waveform. The amplitude of the voltage across the capacitance at each sampling instant is a measure of the capacitance. Hence the capacitance value can be determined. In order to measure the resistive value, a switch is used to apply a DC voltage from a separate source to the component so as to produce a resistive current dependent on the applied DC voltage. Another switch causes the resistive current to flow through another, much smaller, resistance so that the potential drop across the latter is a measure of the current and substantially proportional to the resistance of the component. Such known apparatus and method thus requires two separate sources of voltage: a triangular waveform for use in capacitance measurement and a separate DC voltage for resistance measurement. Switching means therefore has to be provided for switching between the two voltage sources. Accuracy depends on the magnitudes of the applied voltages, and there are thus two sources whose magnitudes have to be controlled in order to achieve accuracy. The invention aims to overcome these problems.

Accordingly, the apparatus is characterised in that the voltage applying means comprises voltage signal generating means for subjecting the electrical component to a voltage signal having an initial voltage of the said first polarity which ramps to a voltage of the said second polarity and remains at a constant voltage of the second polarity for at least a predetermined time period to constitute the said fixed voltage level.

Furthermore, the method is characterised in that the steps of subjecting the component to the time varying voltage and to the fixed voltage level comprise the step of subjecting the electrical component to a voltage signal having an initial voltage of the said first polarity which ramps to a voltage of the said second polarity and remains at a constant voltage of the second polarity for at least a predetermined time period to constitute the said fixed voltage level.

Apparatus embodying the invention and methods according to the invention, for determining capacitance and resistance values of an electrical component, such as a liquid level sensor, will now be described, by way of example only, with reference to the accompanying drawings in which:
Fig. 1 is a schematic block diagram of a circuit of the apparatus; and
Fig. 2 is an idealized graphical illustration of an interrogation waveform used in the circuit of Fig. 1.

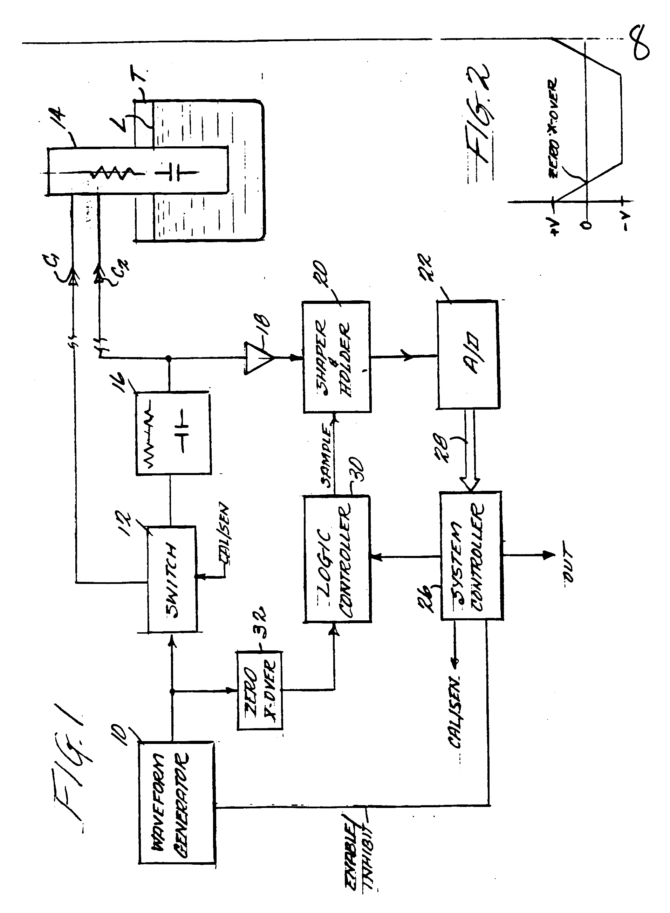

As shown in schematic form in Fig. 1, a waveform generator 10 is connected to a switch 12 which, in turn, provides a switched output to either a sensor unit 14 or a calibration standard 16. As shown, the sensor unit 14 is connected in circuit through a connection interface C1/C2, and if desired, can be located in a remote position from the schematic circuit of Fig. 1. In the preferred embodiment, the sensor unit 14 is a capacitive probe mounted in a tank T containing a selected quantity of a liquid L, such as fuel. The sensor unit 14 and the calibration standard 16 are connected to a preamplifier 18 which provides an amplified output to a sample and hold circuit 20 which functions, as described more fully below, to sense representative voltage potentials from the sensor unit 14 or the calibration standard 16 in response to an appropriate command. The analog output of the sample and hold circuit 20 is provided to an analog-to-digital converter 22 which converts the analog value provided by the sample and hold circuit 20 to a corresponding multi-bit binary value. A system controller 26 accepts the digital values provided via a bus 28 from the analog-to-digital converter 22 and uses those values to compute capacitance and resistance values and provide an appropriate output signal to an output port OUT. The system controller 26 also provides control signals to a logic controller 30 which periodically provides a SAMPLE command to the sample and hold circuit 20 to sense and retain the analog voltage values provided through the preamplifier 18 by either the sensor unit 14 or the calibration standard 16. The system controller 26 also provides appropriate ENABLE/INHIBIT signals to the waveform generator 10 to initiate the capacitance and resistance determination cycle as well as a CAL/SEN signal to the switch 12 to select either the sensor unit 14 for evaluation or the calibration standard 16 to initiate an auto-calibration cycle. In addition, a zero cross-over detector 32 is connected to the output of the waveform generator 10 and provides a signal to the logic controller 30 indicating the moment when the output of the waveform generator 10 passes from a positive value through zero to a negative value and, conversely, passes from a negative value through zero to a positive value.

The waveform generator 10 provides a voltage output having the profile shown in Fig. 2, that is, an initial value of +V that decreases in a linear manner through zero to a -V value and which then remains fixed at -V for a selected period before rising in a linear manner from -V through zero and returning to the +V potential. The output voltage profile shown in Fig. 2 is used to interrogate either the sensor unit 14 or the calibration standard 16 and to determine the respective capacitance and resistance values, as described below. The switch 12 functions as the equivalent of a single-pole, double-throw switch in response to the CAL/SEN signal provided from the system controller 26. When a CAL signal is provided, the switch 12 switches the calibration standard 16 into the circuit to effect auto-calibration and, when the SEN signal is provided, the switch 12 switches the sensor unit 14 into the circuit to determine the capacitance and resistance values of the sensor unit 14. The preamplifier 18 preferably has a high input impedance and a gain appropriate for the waveform repetition rate. The zero cross-over detector 32 functions to detect the cross-over of the linearly declining and rising portions of the voltage profile of Fig. 2 and to provide an appropriate output to the logic controller 30. While a number of devices can perform the zero cross-over detect function, an operational amplifier configured as a differential amplifier driving a bi-stable device can provide the desired output signal to the logic controller 30. The system controller 26 is preferably a stored-program controlled micro-processor including a ROM containing an instruction set for implementing the functions described below, a RAM for storing values presented by the analog-to-digital converter 22, an accumulator, one or more general purpose storage registers, and input/output interfaces.

The circuit of Fig. 1 operates through an interrogation cycle to determine the capacitance and resistance values associated with the calibration standard 16 or the sensor unit 14. Where the sensor unit 14 has been selected by the system controller 26 and the appropriate SEN signal presented to the switch 12, the sensor unit 14 is placed in circuit with the waveform generator 10 and the preamplifier 18 while the calibration standard 16 is effectively disconnected. In response to an ENABLE signal provided from the system controller 26, the waveform generator 10 presents a time varying interrogation voltage through the switch 12 to the sensor unit 14. The interrogation voltage follows the profile shown in Fig. 2, starting at a +V value and declining in a linear manner to the -V value. As the interrogation voltage declines, the capacitance of the sensor unit 14 is charged with the potential rising in a manner inverse to the capacitance value. When the declining interrogation voltage intersects and passes through zero, the zero cross-over detector 32 provides an appropriate signal to the logic controller 30 which commands the sample and hold circuit 20 to sample the output of the preamplifier 18, which output is representative of the capacitance-determined voltage potential of the sensor unit 14. The sampled value is converted to a digital value of selected bit width (e.g., 16 bits) with the digital value presented to the system controller 26 via the bus 28. The system controller 26 then computes the capacitance value for the sensor unit 14 and stores the computed value and/or provides the computed value as an output signal OUT. The capacitance determination can be accomplished by algebraic computation or by table look-up where the sensed voltage level is compared with empirically determined voltages and corresponding capacitance values.

In order to effect the resistance determination, the system controller 26 presents an appropriate control signal to the logic controller 30 so as again to cause the sample and hold circuit 20 to sample the output of the preamplifier 18. This second sample and hold command occurs at a predetermined time period after the detection of the zero crossing when the interrogation voltage is constant at the value -V prior to rising linearly from -V to +V. The predetermined time period is a function of the repetition rate of the waveform generator 10. During the time period that the interrogation voltage is fixed at the value -V, the voltage potential sensed by the preamplifier 18 is solely a function of the resistance of the sensor unit 14 and is independent of any capacitance effect. The output of the sample and hold circuit 20 is provided to the analog-to-digital converter 22 which, in a manner analogous to that described above, provides a multi-bit digital value to the system controller 26 to effect the resistance determination.

In order to ensure the ultimate accuracy of the capacitance and resistance measurements of the sensor 14, an auto-calibration function is performed using the calibration standard 16. Measurement errors and other inaccuracies can arise from a number of sources including the time-varying voltages provided by the waveform generator 10, hysteresis in the zero cross-over detector 32, impedances in the switch 12, and various other offsets and errors. In order to perform an auto-calibration, the system controller 26 provides an appropriate CAL selection signal to the switch 12 to switch the calibration standard 16 into the circuit and effectively disconnect the sensor unit 14. The waveform generator 10 is then enabled by an appropriate command from the system controller 26 to present the interrogation voltage through the switch 12 to the calibration standard 16. The sample and hold circuit 20 then functions in the manner described above to provide output values that are converted to digital values and presented to the system controller 26 for determination of the capacitance and resistance values of the calibration standard 16. Since the capacitance and resistance values of the calibration standard 16 are pre-determined, the difference between the respective values determined by the system controller 26 and the pre-determined values represents a calibration offset. Since the difference values for the capacitance and resistance are in digital form, the difference values are loaded into appropriate registers or memory locations and used to offset the measured values for the sensor unit 14, which offset values can be obtained immediately before or after a measurement cycle using the sensor 14.

As can be appreciated from the above, the method and apparatus described accurately determine capacitance and resistance values for an electrical component including various types of sensors. Additionally, an auto-calibration feature is provided whereby the accuracy of the measurement is enhanced.

This it will be appreciated from the above that a highly effective apparatus and method for determining resistance and capacitance values is provided by which the principal objective, among others, is completely fulfilled. It will be equally apparent and is contemplated that modification and/or changes may be made in the illustrated embodiment without departure from the invention. Accordingly, it is expressly intended that the foregoing description and accompanying drawings are illustrative of preferred embodiments only, not limiting, and that the true spirit and scope of the present invention will be determined by reference to the appended claims and their legal equivalent.

## Claims

1. Apparatus for determining capacitance and resistance characteristics of an electrical component, comprising voltage applying means (10) for subjecting the electrical component (14) to a time varying voltage having a linear ramp voltage which passes from a first polarity through zero to a second polarity and for subjecting the electrical component to a fixed voltage level, sensing means (20) operative in response to the zero crossing of the ramp voltage to sense the electrical potential across the electrical component and for sensing the potential across the electrical component when the voltage is at the fixed voltage level, and means (26) for determining the capacitance of the electrical component from the potential sensed in response to the zero crossing and for determining the resistance of the electrical component from the potential sensed at the fixed voltage level, characterised in that the voltage applying means comprises voltage signal generating means (10) for subjecting the electrical component (14) to a voltage signal having an initial voltage of the said first polarity which ramps to a voltage of the said second polarity and remains at a constant voltage of the second polarity for at least a predetermined time period to constitute the said fixed voltage level.

2. Apparatus according to claim 1, characterised in that, at the end of the predetermined time period, the voltage ramps from the second polarity to the voltage of the first polarity.

3. Apparatus according to claim 1 or 2, characterised in that the sensing means comprises a sample and hold circuit (20) operative when activated to sample the potential across the electrical component (14), and a zero crossing detector (32) for sensing the zero crossing of the waveform and activating the sample and hold circuit (20) in response thereto.

4. Apparatus according to claim 1 or 2, characterised in that the sensing means comprises a sample and hold circuit (20) operative when activated to sense the potential across the component (14), and control means (32,30) operative to activate the sample and hold circuit (20) while the voltage signal is at the constant voltage.

5. Apparatus according to claim 3, characterised in that the sensing means comprises control means (30) operative when a predetermined time duration has elapsed after the said zero crossing to activate the sample and hold circuit (20), the time duration being such that the voltage signal is and remains at the constant voltage of the said second polarity while the sample and hold circuit (20) remains activated.

6. Apparatus according to any preceding claim, characterised by a calibration standard (16), and by switch means (12) for selectively switching the calibration standard (16) in circuit with the voltage applying means (10) and the sensing means (20,30), instead of the electrical component (14).

7. Apparatus according to any preceding claim, characterised in that the electrical component is a capacitive fuel level sensing probe (14).

8. A method of determining capacitive and resistive characteristics of an electrical component (14), comprising the steps of subjecting the component (14) to a time varying voltage having a linear ramp voltage which passes from a first polarity through zero to a second polarity, subjecting the electrical component to a fixed voltage level, sensing the potential across the electrical component (14) in response to the zero crossing of the ramp voltage, sensing the potential across the electrical component when the voltage is at the fixed voltage level, determining the capacitance of the electrical component from the potential sensed in response to the zero crossing, and determining the resistance of the electrical component from the potential sensed at the fixed voltage level, characterised in that the steps of subjecting the component to the time varying voltage and to the fixed voltage level comprise the step of subjecting the electrical component (14) to a voltage signal having an initial voltage of the said first polarity which ramps to a voltage of the said second polarity and remains at a constant voltage of the second polarity for at least a predetermined time period to constitute the said fixed voltage level.

9. A method according to claim 8, in which the component is a capacitive fuel level sensing probe (14), and characterised by the steps of subjecting a calibration standard (16) having known capacitive and resistive characteristics to a time varying voltage including a linear ramp voltage which passes from a first polarity through zero to a second polarity, subjecting the calibration standard (16) to a fixed voltage level, sensing the potential across the calibration standard (16) in response to the zero crossing of the ramp voltage, sensing the potential across the calibration standard (16) when the voltage is at the fixed voltage level, determining the difference in capacitance and resistance of the sensing probe (14) and the calibration standard (16) from the potentials sensed in response to the respective zero crossings and the potentials sensed at the respective fixed voltage levels, and correcting the capacitance and resistance values of the sensing probe (14) as a function of the measured capacitance and resistance values of the calibration standard (16).

## Patentansprüche

1. Vorrichtung zur Bestimmung von Kapazitäts- und Widerstandseigenschaften eines elektrischen Bauteils, mit Spannungsanlegemitteln (10) zum Beaufschlagen des elektrischen Bauteils (14) mit einer zeitveränderlichen Spannung mit einer linearen Rampenspannung, die von einer ersten Polarität durch Null zu einer zweiten Polarität verläuft und zum Beaufschlagen des elektrischen Bauteils mit einem festen Spannungspegel, auf den Nulldurchgang der Rampenspannung reagierende Meßmittel (20) zum Messen des elektrischen Potentials am elektrischen Bauteil und zum Messen des Potentials am elektrischen Bauteil, wenn die Spannung auf dem festen Spannungspegel liegt, und Mitteln (26) zum Bestimmen der Kapazität des elektrischen Bauteils aus dem als Reaktion auf den Nulldurchgang gemessenen Potential und zum Bestimmen des Widerstandes des elektrischen Bauteils aus dem auf dem festen Spannungspegel gemessenen Potential, dadurch gekennzeichnet, daß das Spannungsanlegemittel Spannungssignalgebemittel (10) zum Beaufschlagen des elektrischen Bauteils (14) mit einem Spannungssignal umfaßt, bei dem eine Ausgangsspannung der besagten ersten Polarität sich rampenförmig zu einer Spannung der besagten zweiten Polarität verändert und mindestens eine vorbestimmte Zeitdauer lang auf einer konstanten Spannung der zweiten Polarität verbleibt, um den besagten festen Spannungspegel darzustellen.

2. Vorrichtung nach Anspruch 1, dadurch gekennzeichnet, daß am Ende der vorbestimmten Zeitdauer sich die Spannung rampenförmig von der zweiten Polarität zur Spannung der ersten Polarität verändert.

3. Vorrichtung nach Anspruch 1 oder 2, dadurch gekennzeichnet, daß die Meßmittel eine Abtast- und Halteschaitung (20) umfassen, die bei Ansteuerung das Potential am elektrischen Bauteil (14) abtastet, und einen Nulldurchgangsdetektor (32) zum Messen des Nulldurchgangs der Wellenform und Ansteuern der Abtast- und Halteschaltung (20) als Reaktion darauf.

4. Vorrichtung nach Anspruch 1 oder 2, dadurch gekennzeichnet, daß die Meßmittel eine Abtast- und Halteschaltung (20) umfaßen, die bei Ansteuerung das Potential am Bauteil (14) mißt, und Steuermittel (32, 30) zum Ansteuern der Abtast- und Halteschaltung (20), während das Spannungssignal die konstante Spannung aufweist.

5. Vorrichtung nach Anspruch 3, dadurch gekennzeichnet, daß die Meßmittel Steuermittel (30) umfassen, die nach Ablauf einer vorbestimmten Zeitdauer nach dem besagten Nulldurchgang die Abtast- und Halteschaltung (20) ansteuern, wobei die Zeitdauer eine solche ist, daß das Spannungssignal die konstante Spannung der besagten zweiten Polarität aufweist und auf dieser verbleibt, während die Abtast- und Halteschaltung (20) angesteuert bleibt.

6. Vorrichtung nach einem der vorhergehenden Ansprüche, gekennzeichnet durch ein Eichnormal (16), und durch Schaltermittel (12) zum gezielten Zusammenschalten des Eichnormals (16) mit dem Spannungsanlegemittel (10) und den Meßmitteln (20, 30), anstelle des elektrischen Bauteils (14).

7. Vorrichtung nach einem der vorhergehenden Ansprüche, dadurch gekennzeichnet, daß das elektrische Bauteil eine kapazitive Kraftstoffstand-Meßsonde (14) ist.

8. Verfahren zum Bestimmen der Kapazitäts- und Widerstandseigenschaften eines elektrischen Bauteils (14), mit den Schritten des Beaufschlagen des Bauteils (14) mit einer zeitveränderlichen Spannung mit einer linearen Rampenspannung, die von einer ersten Polarität durch Null zu einer zweiten Polarität verläuft, schlagen des elektrischen Bauteils mit einem festen Spannungspegel, Messen des Potentials am elektrischen Bauteil (14) als Reaktion auf den Nulldurchgang der Rampenspannung, Messen des Potentials am elektrischen Bauteil, wenn sich die Spannung auf dem festen Spannungspegel befindet, Bestimmen der Kapazität des elektrischen Bauteils aus dem als Reaktion auf den Nulldurchgang gemessenen Potential und Bestimmen des Widerstands des elektrischen Bauteils aus dem auf dem festen Spannungspegel gemessenen Potential, dadurch gekennzeichnet, daß die Schritte des Beaufschlagens des Bauteils mit der zeitveränderlichen Spannung und mit dem festen Spannungspegel den Schritt des Beaufschlagens des elektrischen Bauteils (14) mit einem Spannungssignal mit einer Ausgangsspannung der besagten ersten Polarität, die rampenförmig zu einer Spannung der besagten zweiten Polarität verläuft und mindestens eine vorbestimmte Zeitdauer lang auf einer konstanten Spannung der zweiten Polarität verbleibt, um den besagten festen Spannungspegel darzustellen, umfassen.

9. Verfahren nach Anspruch 8, wobei der Bauteil eine kapazitive Kraftstoffstand-Meßsonde (14) ist, und gekennzeichnet durch die Schritte des Beaufschlagens eines Eichnormals (16) mit bekannten Kapazitäts- und Widerstandseigenschaften mit einer zeitveränderlichen Spannung einschließlich einer linearen Rampenspannung, die von einer ersten Polarität durch Null zu einer zweiten Polarität verläuft, Beaufschlagen des Eichnormals (16) mit einem festen Spannungspegel, Messen des Potentials am Eichnormal (16) als Reaktion auf den Nulldurchgang der Rampenspannung, Messen des Potentials am Eichnormal (16), wenn sich die Spannung auf dem festen Spannungspegel befindet, Bestimmen des Unterschieds von Kapazität und Widerstand der Meßsonde (14) und des Eichnormals (16) aus den als Reaktion auf die entsprechenden Nulldurchgänge gemessenen Potentialen und den auf den entsprechenden festen Spannungspegeln gemessenen Potentialen, und Korrigieren der Kapazitäts- und Widerstandswerte der Meßsonde (14) in Abhängigkeit von den gemessenen Kapazitäts- und Widerstandswerten des Eichnormals (16).

## Revendications

1. Dispositif de détermination des caractéristiques de valeur de capacité et de valeur de résistance d'un composant électrique, comprenant un moyen d'application de tension(10) pour soumettre le composant électrique (14) à une tension qui varie au cours du temps et qui présente une tension en rampe linéaire qui passe d'une première polarité à une seconde polarité en passent par zéro, et pour soumettre le composent électrique à un niveau de tension fixe, un moyen de détection (20) qui fonctionne pour détecter le potentiel électrique aux bornes du composant électrique en réponse au passage par zéro de la tension en rampe et pour détecter le potentiel électrique aux bornes du composant électrique lorsque la tension est au niveau de tension fixe, et un moyen (26) pour déterminer la valeur de capacité du composant électrique à partir du potentiel détecté en réponse au passage par zéro et pour déterminer la valeur de résistance du composant électrique à partir du potentiel détecté pour le niveau de tension fixe, caractérisé en ce que le moyen d'application de tension comprend un moyen de génération de signal de tension (10) pour soumettre le composant électrique (14) à un signal de tension présentant une tension initiale de ladite première polarité qui varie en rampe jusqu'à une tension de ladite seconde polarité et qui reste à une tension constante de la seconde polarité pendant au moins une période temporelle prédéterminée afin de constituer ledit niveau de tension fixe.

2. Dispositif selon la revendication 1, caractérisé en ce que, à le fin de la période temporelle prédéterminée, la tension varie en rampe depuis la seconde polarité jusqu'à la tension de le première polarité.

3. Dispositif selon la revendication 1 ou 2, caractérisé en ce que le moyen de détection comprend un circuit échantillonneur/bloqueur (20) qui fonctionne lorsqu'il est activé pour échantillonner le potentiel aux bornes du composant électrique (14) et un détecteur de passage par zéro (32) pour détecter le passage par zéro de la forme d'onde et pour activer le circuit échantillonneur/bloqueur (20) en réponse à ce passage.

4. Dispositif selon la revendication 1 ou 2, caractérisé en ce que le moyen de détection comprend un circuit d'échantillonneur/bloqueur (20) qui fonctionne lorsqu'il est activé pour détecter le potentiel aux bornes du composant (14) et un moyen de commande (32, 30) qui fonctionne pour activer le circuit échantillonneur/bloqueur (20) tandis que le signal de tension est à la tension constante.

5. Dispositif selon la revendication 3, caractérisé en ce que le moyen de détection comprend un moyen de commande (30) qui fonctionne lorsqu'une durée prédéterminée s'est écoulée après ledit passage par zéro afin d'activer le circuit échantillonneur/bloqueur (20), la durée étant telle que le signal de tension est à la tension constante de ladite seconde polarité et y reste tandis que le circuit échantillonneur/bloqueur (20) reste activé.

6. Dispositif salon l'une quelconque des revendications précédentes, caractérisé par un standard d'étalonnage (16) et par un moyen de commutation (12) pour mettre de façon sélective par commutation le standard d'étalonnage (16) en circuit avec le moyen d'application de tension (10) et le moyen de détection (20, 30), en lieu et place du composent électrique (14).

7. Dispositif selon l'une quelconque des revendications précédentes, caractérisé en ce que le composant électrique est une sonde capacitive de détection de niveau de carburant (14).

8. Procédé de détermination des caractéristiques de valeur capacitive et de valeur résistive d'un composant électrique (14), comprenant les étapes de soumission du composant (14) à une tension qui varie au cours du temps et qui présente une tension en rampe linéaire qui passe d'une première polarité à une seconde polarité en passant par zéro, de soumission du composant électrique à un niveau de tension fixe, de détection du potentiel aux bornes du composant électrique (14) en réponse au passage par zéro de la tension en rampe, de détection du potentiel aux bornes du composant électrique lorsque la tension est au niveau de tension fixe, de détermination de la valeur de capacité du composant électrique à partir du potentiel détecté en réponse au passage par zéro, et de détermination de la valeur de résistance du composant électrique à partir du potentiel détecté pour le niveau de tension fixe, caractérisé en ce que les étapes de soumission du composant à la tension qui varie au cours du temps et au niveau de tension fixe comprennent l'étape de soumission de composant électrique (14) à un signal de tension présentant une tension initiale de ladite première polarité qui varie en rampe jusqu'à une tension de ladite seconde polarité et qui reste à une tension constante de la seconde polarité pendant au moins une période temporelle prédéterminée afin de constituer ledit niveau de tension fixe.

9. Procédé selon la revendication 8, dans lequel le composant est une sonde capacitive de détection de niveau de carburant (14) et caractérisé par les étapes de soumission d'un standard d'étalonnage (16) présentant des caractéristiques capacitive et résistive connues, à une tension qui varie au cours du temps et qui inclut une tension en rampe linéaire qui passe d'une première polarité à une seconde polarité en passant par zéro, de soumission du standard d'étalonnage (16) à un niveau de tension fixe, de détection du potentiel aux bornes du standard d'étalonnage (16) en réponse au passage par zéro de la tension en rampe, de détection du potentiel aux bornes du standard d'étalonnage (16) lorsque la tension est au niveau de tension fixe, de détermination de la différence en valeur de capacité et valeur de résistance de la sonde de détection (14) et du standard d'étalonnage (16) à partir des potentiels détectés en réponse aux passages par zéro respectifs et à partir des potentiels détectés pour les niveaux de tension fixe respectifs, et de correction des valeurs de capacité et de résistance de la sonde de détection (14) en fonction des valeurs de capacité et de résistance mesurées du standard d'étalonnage (16).
